(19) Europäisches Patentamt

European Patent Office

Office européen des brevets

(11) **EP 0 642 031 B1**

(12) **EUROPÄISCHE PATENTSCHRIFT**

(45) Veröffentlichungstag und Bekanntmachung des Hinweises auf die Patenterteilung:
**13.11.2002   Patentblatt 2002/46**

(51) Int Cl.$^7$: **G01R 33/56**

(21) Anmeldenummer: **94202483.7**

(22) Anmeldetag: **31.08.1994**

(54) **MR-Abbildungsverfahren und Anordnung zur Durchführung des Verfahrens**

Magnetic resonance imaging method and device for carrying out the method

Procédé pour la formation d'images par résonance magnétique et dispositif pour la mise en oeuvre du procédé

(84) Benannte Vertragsstaaten:
DE FR GB NL

(30) Priorität: **04.09.1993   DE 4329922**

(43) Veröffentlichungstag der Anmeldung:
**08.03.1995   Patentblatt 1995/10**

(73) Patentinhaber:
• **Philips Corporate Intellectual Property GmbH
20099 Hamburg (DE)**
Benannte Vertragsstaaten:
**DE**
• **Koninklijke Philips Electronics N.V.
5621 BA Eindhoven (NL)**
Benannte Vertragsstaaten:
**GB FR NL**

(72) Erfinder:
• **Holz, Dietrich Joachim Karl, Dr.
D-24558 Henstedt-Ulzburg (DE)**
• **Kuhn, Michael Harald, Dr.-Ing.
D-22457 Hamburg (DE)**

(74) Vertreter: **Hartmann, Heinrich, Dipl.-Ing. et al
Philips Corporate Intellectual Property GmbH,
Habsburgerallee 11
52064 Aachen (DE)**

(56) Entgegenhaltungen:
EP-A- 0 430 322          EP-A- 0 488 496
WO-A-92/06386          DE-A- 3 918 625
GB-A- 2 101 327          US-A- 4 602 641

• MAGNETIC RESONANCE IN MEDICINE., Bd.12, Nr.1, 1. Oktober 1989, DULUTH,MN US Seiten 99 - 113 H.W. KORIN ET AL. 'COMPENSATION FOR EFFECTS OF LINEAR MOTION IN MR IMAGING'

**Beschreibung**

Die Erfindung betrifft ein MR-Abbildungsverfahren, nach dem Oberbegriff des Anspruchs 1, sowie eine Anordnung zur Durchführung des Verfahrens.

Ein solches Verfahren ist aus der EP-A-430 322 bekannt. Bei diesem Verfahren wird eine Anzahl von eindimensionalen bzw. zeilenförmigen, zur Bewegungsrichtung senkrechten MR-Bildern erzeugt, die zusammen ein zweidimensionales MR-Bild ergeben. Der Vorteil dieses Verfahrens besteht darin, daß noch beim Einfahren des Patienten in den Untersuchungsbereich ein Übersichtsbild erzeugt werden kann. Das Problem dieses Verfahrens besteht darin, daß relativ zur Bewegungsgeschwindigkeit schnell gemessen werden muß, was ein ungünstiges Signal/Rauschverhältnis zur Folge hat. Wenn zwecks Verbesserung des Signal/Rauschverhältnisses weniger schnell gemessen wird (d.h. wenn die Repetitionszeit zwischen zwei Sequenzen größer wird), dann verschlechtert sich das räumliche Auflösungsvermögen und es können Bewegungsartefakte auftreten.

Diese Bewegungsartefakte werden bei einem aus Magn. Reson. Med. 12 (1989), Seiten 99-113, bekannten Verfahren der eingangs genannten Art durch nachträgliche Phasen-Korrekturen der empfangen MR-Signale vermieden. Dieses Verfahren funktioniert allerdings nur bei der Erzeugung von MR-Bildern von parallel zur Bewegungsrichtung des Untersuchungsobjektes orientierten Schichten.

Aufgabe der vorliegenden Erfindung ist es, ein Verfahren der eingangs genannten Art anzugeben, das auch bei MR-Bildern von senkrecht oder schräg zur Bewegungsrichtung des Untersuchungsobjektes orientierten Schichten eine gute Bildqualität liefert und praktisch frei von Bewegungsartefakten ist. Diese Aufgabe wird erfindungsgemäß durch die im kennzeichnenden Teil von Anspruch 1 angegebenen Maßnahmen gelöst.

Bei der Erfindung werden also die für die Sequenz maßgebenden Parameter so eingestellt, daß der im MR-Bild abgebildete Bereich des Untersuchungsobjekts sich synchron mit diesem mitbewegt. Welcher Parameter entsprechend der Position des Untersuchungsobjekts gewählt werden muß, hängt davon ab, welches der für ein MR-Abbildungsverfahren unerläßlichen Gradientenfelder in der Bewegungsrichtung des Untersuchungsobjektes verläuft:

a) Wenn das mit einem schichtselektiven Hochfrequenzimpuls verbundene magnetische Gradientenfeld einen in der Bewegungsrichtung des Untersuchungsobjektes verlaufenden Gradienten aufweist, dann muß die Frequenz des Hochfrequenzimpulses angepaßt werden. Durch diesen schichtselektiven Hochfrequenzimpuls wird nämlich die Kernmagnetisierung in einer zur Bewegungsrichtung senkrechten Schicht angeregt. Wenn die Frequenz der Hochfrequenzimpulse proportional zur Position des Untersuchungsobjektes variiert wird, so daß diese Frequenz mit der Larmorfrequenz (die der Stärke des sich durch die Überlagerung des stationären homogenen Magnetfeldes und des magnetischen Gradientenfeldes ergebenden Feldes proportional ist), in einem bestimmten Punkt des Objektes übereinstimmt, dann bewegt sich die durch den schichtselektiven Hochfrequenzimpuls angeregte Schicht synchron mit dem Untersuchungsobjekt mit.

Es sei an dieser Stelle erwähnt, daß es bei MR-Abbildungen von "Offcenter"-Bereichen (das sind außerhalb des Zentrums des Untersuchungsbereiches befindliche Bereiche) bekannt ist, die Sequenz der Hochfrequenzimpulse so zu verändern, daß sie mit der Larmorfrequenz in diesem Bereich übereinstimmt. Allerdings wird das Objekt dabei nicht bewegt. - Weiterhin ist es aus der US-A-5,042,485 bei einem ruhenden Patienten bekannt, zunächst die Korrelation zwischen der Wurzel der Aorta und dem EKG-Signal zu bestimmen und bei einer anschließenden MR-Untersuchung die Frequenz der Hochfrequenzimpulse in Abhängigkeit von dem EKG-Signal zu variieren, um die Wurzel der Arorta scharf abzubilden. Dabei wird davon ausgegangen, daß sich die Wurzel der Aorta reproduzierbar periodisch mit dem EKG-Signal bewegt. Wenn überhaupt, können mit diesem Verfahren nur Bewegungen in einer Richtung korrigiert werden und der im MR-Bild enthaltene Bereich, der nicht synchron mit der Wurzel bewegt wird, kann nicht frei von Artefakten wiedergegeben werden.

b) Wenn der während der Erfassung des MR-Signals wirksame Gradient, der sogenannte Lesegradient, in der Richtung verläuft, in der das Untersuchungsobjekt bewegt wird, dann muß die Frequenz des Oszillatorsignals, mit dem das hochfrequente MR-Signal in einen niedrigeren Frequenzbereich umgesetzt wird, linear mit der Position des Untersuchungsobjektes geändert werden, so daß die Änderungen der Frequenz des MR-Signals, die sich aus der Bewegung des Untersuchungsobjektes ergeben, kompensiert werden.

c) Wenn der Phasenkodierungsgradient, d.h. der Gradient des magnetischen Gradientenfeldes, das zwischen dem Hochfrequenzimpuls und dem Empfangen des MR-Signals wirksam ist, in der Bewegungsrichtung des Untersuchungsobjektes verläuft, dann muß die Phasenlage des zur Frequenzumsetzung des MR-Signals herangezogenen Oszillatorsignals variiert werden, um Bewegungsartefakte zu vermeiden.. Da die durch die Phasenkodierungsgradienten hervorgerufene Änderung der Phasenlage des MR-Signals nämlich auch von der Position des Untersuchungsobjektes abhängt, kann durch eine Änderung der Phasenlage eine Änderung der Position des Untersuchungsobjektes berücksichtigt werden.

Eine MR-Anordnung zur Durchführung des erfindungsgemäßen Verfahrens ist in Anspruch 2 angegeben.

Die Erfindung wird nachstehend anhand der Zeichnungen näher erläutert. Es zeigen:

Fig. 1      ein Kernspintomographiegerät, mit dem die Erfindung durchführbar ist.

Fig. 2      eine für das erfindungsgemäße Verfahren geeignete Sequenz,

Fig. 3      die Änderung verschiedener Parameter bei aufeinanderfolgenden Sequenzen,

Fig. 4      ein vereinfachtes Blockschaltbild eines Kernspintomographiegerätes.

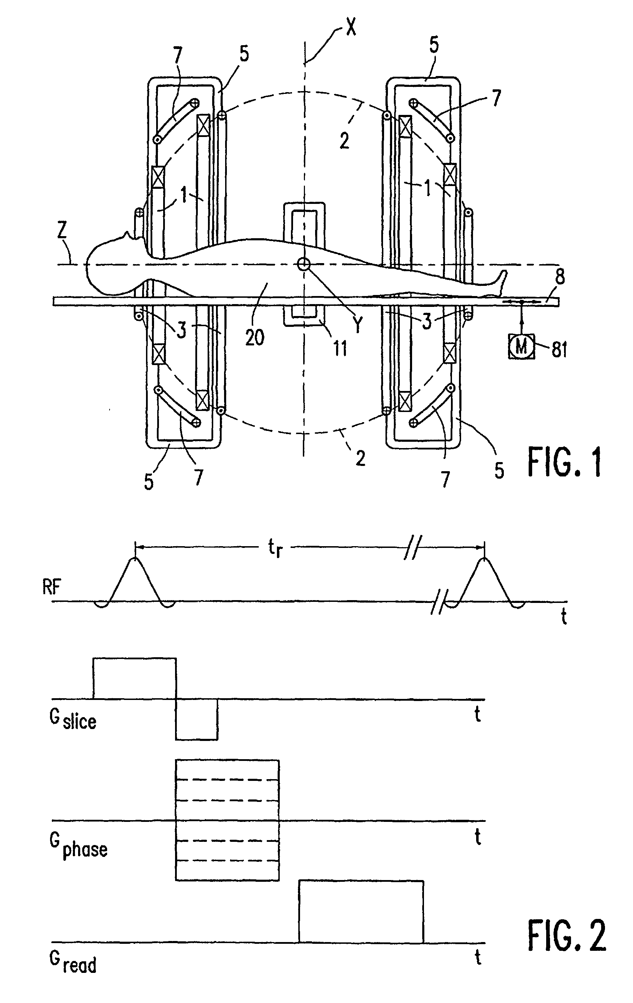

Der in Fig. 1 schematisch dargestellte Kernspintomograph enthält eine aus vier Spulen 1 bestehende Anordnung zur Erzeugung eines homogenen stationären Magnetfeldes, das Bruchteile von Tesla, aber auch einige Tesla stark sein kann. Dieses Feld verläuft in z-Richtung eines kartesischen Koordinatensystems (horizontal in Fig. 1). Die zur z-Achse konzentrisch angeordneten Spulen können auf der Oberfläche 2 einer Kugel angeordnet sein, deren Mittelpunkt das sogenannte Isozentrum bildet. Im Innern dieser Spulen befindet sich der zu untersuchende Patient 20, der auf einer Tischplatte 8 gelagert ist. Die Tischplatte 8 ist mittels eines Motorantriebs 81 in z-Richtung, d.h. in Längsrichtung des Patienten verschiebbar.

Zur Erzeugung eines in z-Richtung verlaufenden und sich in dieser Richtung linear ändernden Magnetfeldes $G_z$ sind vier Spulen 3 vorzugsweise auf der Kugeloberfläche 2 angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) $G_x$ erzeugen, dessen Gradient jedoch in x-Richtung verläuft. Ein in z-Richtung verlaufendes magnetisches Gradientenfeld $G_y$ mit einem Gradienten in y-Richtung wird von vier Spulen 5 erzeugt, die die gleiche Form haben können wie die Form 7, jedoch diesen gegenüber um 90° versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder $G_z$, $G_y$ und $G_x$ symmetrisch zur Kugeloberfläche 2 angeordnet ist, ist die Feldstärke im Kugel- bzw. Isozentrum, das gleichzeitig den Ursprung des erwähnten kartesischen x,y,z-Koordinatensystems bildet, nur durch das stationäre Magnetfeld der Spulenanordnung 1 bestimmt.

Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochfrequent modulierter Strom von einem Hochfrequenzgenerator zugeführt. Im Anschluß an eine Sequenz dient die Hochfrequenzspule 11 oder eine gesonderte Hochfrequenzempfangsspule zum Empfangen der im Untersuchungsbereich erzeugten MR-Signale.

Bei dem erfindungsgemäßen Verfahren verschiebt der Motorantrieb 81 die Tischplatte 8 und damit den Patienten 20 relativ zum Untersuchungsbereich, der durch die Spulen 1, 3, 5, 7 bzw. durch das Isozentrum definiert ist. Während dieser mit genau definiertem Geschwindigkeitsverlauf (vorzugsweise mit konstanter Geschwindigkeit) erfolgenden Verschiebung wirken eine Vielzahl von Sequenzen nacheinander auf den Untersuchungsbereich ein.

Fig. 2 zeigt die zeitliche Lage verschiedener Signale bei einer dieser Sequenzen. In der ersten Zeile ist die zeitliche Lage der Hochfrequenzimpulse RF dargestellt, wobei im Beispiel davon ausgegangen ist, daß jede Sequenz nur einen Hochfrequenzimpuls umfaßt. Die Frequenz f dieses Hochfrequenzimpulses stimmt im allgemeinen mit der Larmorfrequenz im Zentrum der Kugel 2 (Fig. 1) überein, wobei die Beziehung gilt

$$f = \gamma \cdot B,$$

wobei f die Frequenz des Hochfrequenzimpulses bzw. die Larmorfrequenz ist, B die Dichte des magnetischen Induktionsflusses in dem von den Spulen 1 erzeugten homogenen stationären Magnetfeld repräsentiert und $\gamma$ die sogenannte gyromagnetische Konstante ist (ca. 42 MHZ/T).

Während des Hochfrequenzimpulses RF wird ein magnetisches Gradientenfeld $G_{slice}$ ein- und ausgeschaltet (2. Zeile von Fig. 2) derart, daß durch diesen Hochfrequenzimpuls die Kernmagnetisierung lediglich in einer zur Richtung des Gradienten von $G_{slice}$ senkrechten Schicht angeregt wird.

Nach dem Hochfrequenzimpuls und bevor das dadurch erzeugte MR-Signal ausgelesen wird, wird ein magnetisches Gradientenfeld $G_{phase}$ ein- und ausgeschaltet (dritte Zeile von Fig. 2), dessen zeitliches Integral in der Regel von Sequenz zu Sequenz in gleich großen Stufen verändert wird. Üblicherweise wird dieser Gradient als Phasenkodierungsgradient bezeichnet.

Danach wird ein magnetisches Gradientenfeld $G_{read}$ wirksam. Das während dieses Gradienten im Untersuchungsbereich entstehende MR-Signal wird zur Erzeugung eines MR-Bildes herangezogen.

Das in Fig. 2 dargestellte Verfahren, bei dem die Gradienten $G_{read}$, $G_{phase}$ und $G_{slice}$ senkrecht zueinander verlaufen, ist als 2DF-Verfahren bekannt. Die Erfindung ist aber auch bei dem sogenannten 3DF-Verfahren anwendbar (in diesem Fall wird ein zweiter Phasenkodierungsgradient geschaltet, der senkrecht zu dem ersten Phasenkodierungsgradienten und dem Lesegradienten $G_{read}$ verläuft). Bei der sogenannten Projektions-Rekonstruktions-Methode, bei der kein Phasenkodierungsgradient wirksam ist, und bei der die Richtung des Lesegradienten von Sequenz zu Sequenz variiert wird, kann die Erfindung nur dann angewandt werden, wenn der Schichtgradient $G_{slice}$ in der Bewegungsrichtung verläuft.

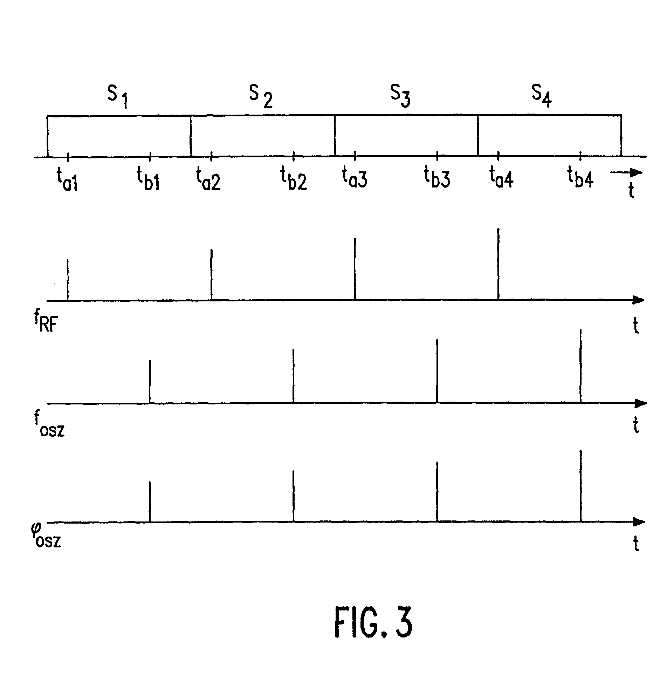

Die Sequenz wird nach einer Repetitionszeit $t_r$ mit geänderten Parametern wiederholt. Die Parameteränderungen, die erforderlich sind, damit der im MR-Bild abgebildete Bereich des Untersuchungsobjektes sich synchron mit diesem verschiebt, werden nachfolgend anhand der Fig. 3 näher erläutert, die die Änderung dieser Parameter bei vier aufeinanderfolgenden Sequenzen darstellt. Die erste Zeile von Fig. 3 zeigt die vier Sequenzen $S_1 ... S_4$ als aufein-. anderfolgende rechteckige Blöcke, wobei die Zeitpunkte $t_{a1} ... t_{a4}$ die Zeitpunkte innerhalb der Sequenzen $S_1 ... S_4$ bezeichnen, in denen die Hochfrequenzimpulse RF erzeugt werden (vergl. Fig. 2) und wobei $t_{b1} ... t_{b4}$ die Mitte des Zeitraums bezeichnet, während dessen der Lesegradient $G_{read}$ eingeschaltet ist (4. Zeile von Fig. 2).

Welcher Parameter mit der Patientenbewegung von Sequenz zu Sequenz geändert werden muß, hängt von der Lage der abzubildenden Schicht relativ zur Bewegungsrichtung ab. Hier sind folgende Fälle möglich:

a) Die Schicht verläuft senkrecht zur z-Achse, d.h. sie liegt in einer vertikalen, zur Zeichenebene der Fig. 1 senkrechten Ebene. In diesem Fall ist der Schichtselektionsgradient $G_{slice}$ mit $G_z$ identisch bzw. $G_{slice}$ verläuft in Richtung der Bewegung des Patienten 20. Bei den üblichen 2DF-Verfahren verläuft diese Schicht durch das Zentrum der Kugel 2 (Fig. 1), und die Frequenz der Hochfrequenzimpulse ist mit der Larmorfrequenz im Zentrum der Kugel 2 identisch. Bei der Erfindung muß sich die Lage der Schicht relativ zum Kugelzentrum fortlaufend ändern, weil diese Schicht ja synchron mit dem Patienten mitbewegt. Infolgedessen muß die Frequenz $f_{RF}$ der Hochfrequenzimpulse von Sequenz zu Sequenz entsprechend dem jeweiligen Abstand der Schicht vom Isozentrum geändert werden, wie in der zweiten Zeile von Fig. 3 übertrieben dargestellt ist. Für die Frequenzänderung df zwischen zwei aufeinanderfolgenden Sequenzen gilt die Beziehung:

$$df = \gamma \cdot G_{slice} \cdot dz \qquad (1)$$

wobei dz die Verschiebung des Patienten zwischen zwei aufeinanderfolgenden Sequenzen darstellt. Wenn die Tischplatte mit einer konstanten Geschwindigkeit v verschoben wird, errechnet sich dz nach der Beziehung

$$dz = v \cdot t_r \qquad (2)$$

Dabei wird v positiv angenommen, wenn die Tischplatte sich in der Richtung bewegt, in der das Magnetfeld zunimmt und negativ, wenn sie sich in der entgegengesetzten Richtung bewegt.

b) Der Lesegradient $G_{read}$ verläuft in z-Richtung, d. h. es wird eine zur z-Achse parallele (horizontale oder vertikale) Schicht angeregt. - Um den Effekt der Bewegung des Patienten in Richtung des Lesegradienten zu erkennen, sei die Akquisition von zwei MR-Signalen durch zwei im zeitlichen Abstand tr aufeinanderfolgende Sequenzen betrachtet, wobei bei der ersten Sequenz sich ein Spinpaket am Ort $z_1$ befinden möge. Der Frequenzunterschied $f_1$ zwischen diesem Spinpaket und einem Spinpaket im Kugelzentrum ist gegeben durch

$$f_1 = \gamma \cdot G_{read} \cdot Z_1 \qquad (3)$$

Für das gleiche Spinpaket gilt bei der zweiten Sequenz, bei der es sich am Ort $z_1 + dz$ befindet, für den Frequenzunterschied $f_2$ gegenüber dem Kugelzentrum

$$f_2 = \gamma \cdot G_{read} \cdot (z_1 + dz) \qquad (4)$$

Während also ein Spinpaket in einem ruhenden Patienten immer mit der gleichen Frequenz präzediert, ändert sich bei einer Verschiebung die Präzessionsfrequenz von Sequenz zu Sequenz entsprechend der Gleichung

$$df = f_2 - f_1 = \gamma \cdot G_{read} \cdot dz \qquad (5)$$

Die mit der Verschiebung des Patienten einhergehenden Bewegungsartefakte lassen sich also vermeiden, wenn die Oszillatorfrequenz $f_{osz}$, mit der in dem Empfänger das MR-Signal in ein niedrigeres Frequenzband umgesetzt wird, in gleichem Maße geändert wird wie die Präzessionsfrequenz. Zwischen zwei aufeinanderfolgenden Sequenzen muß die Oszillatorfrequenz $f_{osz}$ also um df entsprechend Gleichung (5) geändert werden. Dies ist in der dritten Zeile von Fig. 3 für vier aufeinanderfolgende Sequenzen dargestellt, wobei angenommen ist, daß die Bewegung in der Richtung erfolgt, in der während des Auslesens die magnetische Feldstärke zunimmt.

c) Schließlich kann der Phasenkodierungsgradient $G_{phase}$ in der Bewegungsrichtung, (d.h. in z-Richtung) verlaufen, wenn eine zur z-Achse parallele, horizontale oder vertikale Schicht des Patienten untersucht wird. Der Phasenkodierungsgradient beeinflußt die Phase der von einem Spinpaket hervorgerufenen Signalkomponenten des MR-Signals in Abhängigkeit von dem Abstand dieses Spinpakets vom Kugelzentrum. Um auch in diesem Fall das Bildfeld synchron mit dem Patienten mitwandern zu lassen, wird von Sequenz zu Sequenz die Phase $\varphi_{osz}$ des Oszillatorsignals entsprechend dem Vorschub der Tischplatte geändert, mit dem das MR-Signal im Empfänger in einen niedrigeren Frequenzbereich transponiert wird. Dabei wird von der Überlegung ausgegangen, daß sich infolge der Verschiebung des Patienten die Phasenlage für ein bestimmtes Spinpaket im Patienten in anderer Weise als Funktion des Ortes ändert, als sie es bei ruhendem Patienten tun würde. Man kann dies dadurch kompensieren, daß man das MR-Signal mit einem entsprechend in der Phase versetzten Signal mischt. Für die Phasenänderung bei zwei aufeinanderfolgende Sequenzen gilt dabei

$$d\varphi = 2\pi \cdot v \cdot t_r/F_{ov} \qquad (6)$$

Dabei ist $F_{ov}$ die Größe des Abbildungsbereiches in Bewegungsrichtung. Gleichung (6) besagt, daß die Phase des Oszillatorsignals, mit dem das MR-Signal in dem Empfänger gemischt wird, von Sequenz zu Sequenz um einen konstanten Betrag geändert werden muß, wie in der vierten Zeile von Fig. 3 angedeutet.

d) In dem allgemeinsten Fall, daß die zu rekonstruierende Schicht schräg (unter einen von 90° verschiedenen Winkel) zur Bewegungsrichtung verläuft, müssen die in Fig. 3 angedeuteten Maßnahmen gleichzeitig angewandt weren (Änderung von $f_{RF}$, $f_{osz}$ und $\varphi_{osz}$ von Sequenz zu Sequenz entsprechend der jeweiligen Position des Untersuchungsobjektes).

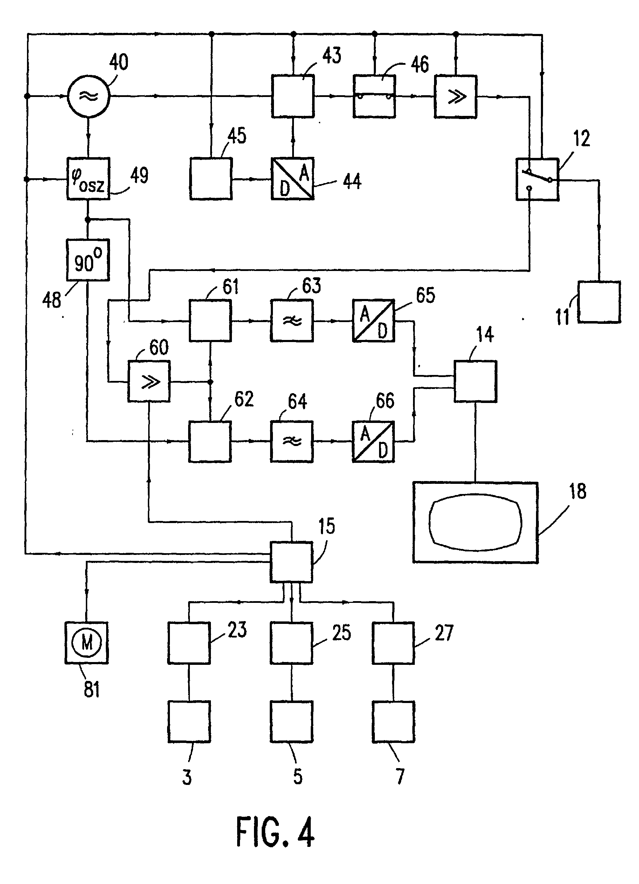

Fig. 4 zeigt das Blockschaltbild eines Kernspintomographen, mit dem das erfindungsgemäße Verfahren durchführbar ist. Ein in seiner Frequenz durch eine Steuereinheit 15 digital steuerbarer Hochfrequenzoszillator 40 liefert Schwingungen mit einer Frequenz entsprechend der Larmorfrequenz der anzuregenden Atomkerne. Der Ausgang des Oszillators 40 ist mit einem Eingang eines Modulators 43 verbunden. Dem Modulator wird ein Modulationssignal von einem Digital-Analog-Wandler 44 zugeführt, dessen Ausgang mit einem digitalen Speicher 45 verbunden ist. Im Speicher 45 sind eine Anzahl von Hüllkurvensignalen - jedes als Folge digitaler Datenworte - gespeichert, von denen bei jeder Sequenz eins ausgelesen wird. Der Modulator 43 verarbeitet die ihm zugeführten Eingangssignale so, daß an seinem Ausgang die mit dem Hüllkurvensignal modulierte Trägerschwingung erscheint. Das Ausgangssignal der Mischstufe wird über einen der Steuereinheit 15 gesteuerten Schalter 46 einem Hochfrequenz-Leistungsverstärker 47 zugeführt, dessen Ausgang mit einer ebenfalls von der Steuereinheit 15 steuerbaren Umschalteinrichtung 12 verbunden ist. An die Umschalteinrichtung ist die Hochfrequenzspule 11 angeschlossen. Während der Erzeugung der Hochfrequenzimpulse ist der Schalter 46 geschlossen, und die Umschalteinrichtung 12 nimmt ihre in der Zeichnung dargestellte Stellung ein.

In der entgegengesetzten Schaltstellung befindet sich die Umschalteinrichtung, wenn der Lesegradient $G_{read}$ ein- und ausgeschaltet wird. Die Hochfrequenzspule 11 empfängt dann das in dieser Zeitspanne im Untersuchungsbereich auftretende MR-Signal. Dieses MR-Signal wird einem Hochfrequenzverstärker 60 zugeführt, der einen von der Steuereinrichtung 15 gesteuerten Schalteingang besitzt, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils ein dem Produkt ihrer Eingangssignale entsprechendes Ausgangssignal liefern. Der zweite Eingang der Mischstufe 61 ist mit dem Ausgang eines Phasendrehgliedes 49 verbunden, das das von dem Oszillator 40 zugeführte Oszillatorsignal um einen durch die Steuereinheit 15 einstellbaren Betrag in der Phase dreht. Der zweite Eingang der Mischstufe 62 ist an den Ausgang eines 90°-Phasendrehgliedes 48 angeschlossen, dessen Eingang mit dem Ausgang des Phasendrehgliedes 49 verbunden ist. Infolgedessen wird das MR-Signal in den Mischstufen 61 und 62 mit zwei gegeneinander um 90° in den Phase versetzten Schwingungen mit der Oszillatorfrequenz $f_{osz}$ gemischt.

Die Ausgangssignale der Mischstufen 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadraturdemodulator bildenden Schaltung 61 .. 64 in digitale Datenworte um. Die Analog-Digital-Wandler 65 und 66 Speicher 14 erhalten ihre Taktimpulse von einem Taktimpulsgenerator 16, der von der Steuereinheit 15 so gesteuert wird, daß nur in dem durch das Einschalten des Lesegradienten $G_{read}$ definierten Zeitintervall die von der Hohfrequenzspule 11 gelieferten, in den Niederfrequenzbereich transponierten Signale in eine Folge digitaler Datenworte umgesetzt werden können. Eine Bildverarbeitungseinheit 14 rekonstruiert aus den Datenworten einer Vielzahl von MR-Signalen die Kernmagnetisierungsverteilung im Untersuchungsbereich und gibt diese auf einem Monitor 18 wieder. Die Steuereinheit 15 steuert darüberhinaus noch den Motor 81 für die Tiefplattenbewegung, z.B. einen Schrittmotor, so daß zu jedem Zeitpunkt die Position der Tischplatte 8 genau definiert ist. Außerdem sind für die Gradientenspulen 3, 5 und 7 (Fig. 1) steuerbare Stromquellen 23, 25 und 27 vorgesehen, die an die Stromquellen Ströme liefern, deren zeitlicher Verlauf durch die Steuereinheit 15 steuerbar ist.

Bei der üblichen Anwendung des anhand der Sequenz in Fig. 2 dargestellten 2DF-Verfahrens hat die Oszillatorfrequenz $f_{osz}$ beim Erzeugen der Hochfrequenzimpulse jeweils denselben Wert, der der Larmorfrequenz im Zentrum der Kugel 2 entspricht. Auch beim Empfangen der MR-Signale ändert sich die Oszillatorfrequenz nicht. Der einzige Parameter, der von Sequenz zu Sequenz geändert wird, ist der Phasenkodierungsgradient.

Damit der im MR-Bild abgebildete bereich des Untersuchungsobjekts sich synchron mit diesem mitbewegt, müssen sich weitere Parameter ändern :

a) Wenn während des Einfahrens MR-Bilder einer zur Bewegungsrichtung senkrechten Schicht erzeugt werden sollen, muß die Frequenz $f_{RF}$ der Hochfrequenzimpulse von Sequenz zu Sequenz geändert werden (2. Zeile von Fig. 3). Dies erfordert, daß die Steuereinheit 15 den Oszillator 40 so steuert, daß er Schwingungen mit einer entsprechenden Frequenz liefert. Beim Empfang der durch die Hochfrequenzimpulse in den einzelnen Sequenzen erzeugten MR-Signale darf sich die Oszillatorfrequenz jedoch nicht ändern, d.h., sie muß der Larmorfrequenz in dem von magnetischen Gradientenfelder freien Zentrum der Kugel 2 (Fig. 1) entsprechen.

b) Wenn der Lesegradient $G_{read}$ in Bewegungsrichtung verläuft, bleibt die Frequenz der Hochfrequenzimpulse $f_{RF}$ in allen Sequenzen unverändert; sie entspricht der Larmorfrequenz im Zentrum der Kugel. Hingegen muß die Frequenz $f_{osz}$ mit der die MR-Signale in den Mischstufen 61 und 62 gemischt werden, von Sequenz zu Sequenz geändert werden. Dies erfordert, daß der Oszillator 40 durch die Steuereinheit 15 ständig zwischen einer konstanten Frequenz beim Senden und einer von Sequenz zu Sequenz geänderten Frequenz beim Empfangen des MR-Signales hin- und hergeschaltet wird.

c) Wenn der Phasenkodierungsgradient in der Bewegungsrichtung verläuft, bleibt die Oszillatorfrequenz bei allen Sequenzen sowohl beim Erzeugen der Hochfrequenzimpulse als auch beim Empfangen der MR-Signale gleich. Jedoch wird die Phasenverschiebung durch das von der Steuereinheit 15 gesteuerte Phasendrehglied 49 von Sequenz zu Sequenz entsprechend der letzten Zeile in Fig. 3 geändert.

Das erfindungsgemäße Verfahren ändert gemäß a) die Frequenz $f_{RF}$ wenn die Schicht senbrecht zur lewegungsrichtung orientiert ist, und ändert ggf. zusätzlich die Frequenz und/oder Phasenlage des Oszillatorsignals bei schräg orientierter Schicht.

Die in Fig. 4 dargestellte Anordnung verarbeitet die MR-Signale bis zum Ausgang des Quadraturdemodulators 61 ... 64 analog. Die Erfindung ist aber auch anwendbar, wenn die MR-Signale weitgehend digital verarbeitet werden. Das gleiche gilt auch für die Erzeugung des Hochfrequenzsignals.

Weiterhin wurde davon ausgegangen, daß zum Senden der Hochfrequenzimpulse und zum Empfangen der dadurch erzeugten MR-Signale die gleiche Hochfrequenzspule benutzt wird. Die Erfindung ist aber auch anwendbar, wenn zum Empfang der MR-Signale eine gesonderte Hochfrequenzspule verwendet wird. Diese kann mit dem Patienten mitbewegt werden oder ortsfest angeordnet werden. In diesem Fall empfiehlt sich die Verwendung eines aus mehreren Teilspulen zusammengesetzten Spulen-Arrays.

## Patentansprüche

1. MR-Abbildungsverfahren, bei dem ein Untersuchungsobjekt relativ zu einem Untersuchungsbereich mit definierter Geschwindigkeit bewegt wird und bei dem in Anwesenheit des stationären homogenen Magnetfeldes eine Vielzahl von Sequenzen auf den Untersuchungsbereich einwirkt, die jeweils wenigstens einen Hochfrequenzimpuls und wenigstens ein magnetisches Gradientenfeld umfassen und jeweils ein MR-Signal liefern, das nach Umsetzung mittels eines Oszillatorsignals in einen anderen Frequenzbereich zur Erzeugung eines MR-Bildes herangezogen wird,
**dadurch gekennzeichnet,**
**daß** zur Erzeugung eines MR-Bildes einer zur Bewegungsrichtung senkrecht oder schräg orientierten Schicht von Sequenz zu Sequenz

a) die Frequenz der Hochfrequenzimpulse und ggf. zusätzlich, bei schräg orientierter Schicht,
b) die Frequenz und/oder die Phasenlage des Oszillatorsignals

entsprechend der Position des Untersuchungsobjektes relativ zum Untersuchungsbereich so eingestellt wird, daß der im MR-Bild abgebildete Bereich des Untersuchungsobjektes sich synchron mit diesem mitbewegt.

2. MR-Anordnung zur Durchführung des Verfahrens nach Anspruch 1 mit

- einer Lagerungsanordnung zur Lagerung eines Untersuchungsobjektes

- Antriebsmitteln zum Verschieben der Lagerungsanordnung mit definierter Geschwindigkeit,
- einem Magneten zur Erzeugung eines homogenen stationären Magnetfeldes,
- Mitteln zum Erzeugen von Hochfrequenzimpulsen mit vorgebbarer Frequenz,
- einer Gradientenspulenanordnung zur Erzeugung von magnetischen Gradientenfeldern,
- Mitteln zum Empfangen der in einem Untersuchungsbereich entstehenden MR-Signale, wobei jedes MR-Signal mittels eines Oszillatorsignals in einen anderen Frequenzbereich umgesetzt wird,
- Mitteln zum Erzeugen von MR-Bildern, aus den in der Frequenz umgesetzten MR-Signalen,
- einer Steuereinheit, die so eingerichtet ist, daß sie die Antriebsmittel, die Mittel zur Erzeugung von Hochfrequenzimpulsen, die Gradientenspulenanordnung und die Mittel zum Empfangen der MR-Signale so steuert, daß während des Vorschubes der Lageranordnung eine Vielzahl von Sequenzen auf den Untersuchungsbereich einwirkt, die jeweils ein MR-Signal liefern, **dadurch gekennzeichnet, dass** zur Erzeugung eines MR-Bildes einer zur Bewegungsrichtung senkrecht oder schräg orientierten Schicht von Sequenz zu Sequenz

  a) die Frequenz der Hochfrequenzimpulse und ggf. zusätzlich, bei schräg orientierter Schich
  b) die Frequenz und/oder die Phasenlage des Oszillatorsignals

entsprechend der Position des Untersuchungsobjektes relativ zum Untersuchungsbereich so eingestellt ist, dass der im MR-Bild abgebildete Bereich des Untersuchungsobjektes sich synchron mit diesem mitbewegt.

**Claims**

1. An MR imaging method in which an object to be examined is moved at a defined speed relative to an examination zone and a plurality of sequences acts on the examination zone in the presence of the steady, uniform magnetic field, each of said sequences comprising at least one RF pulse and at least one magnetic gradient field and supplying a respective MR signal which, after transposition to another frequency range by way of an oscillator signal, is used to form MR an image, **characterized in that**, in order to form an MR image of a slice which is oriented perpendicularly or obliquely to the direction of motion, from one sequence to another

a) the frequency of the RF pulses and possibly additionally, in the case of an obliquely oriented slice,
b) the frequency and/or the phase position of the oscillator signal

is adjusted in conformity with the position of the object to be examined relative to the examination zone in such a manner that the part of the object which is imaged in the MR image moves in synchronism with the object.

2. An MR device for carrying out the method claimed in Claim 1, comprising

- a supporting device for supporting an object to be examined
- drive means for displacing the supporting device at a defined speed,
- a magnet for generating a uniform, steady magnetic field,
- means for generating RF pulses of predefined frequency,
- a gradient coil system for generating magnetic gradient fields,
- means for receiving the MR signals arising in an examination zone, each MR signal being transposed to another frequency range by means of an oscillator signal,
- means for forming MR images from the frequency-transposed MR signals,
- a control unit which is arranged to control the drive means, the means for generating RF pulses, the gradient coil system and the means for receiving the MR signals, in such a manner that a plurality of sequences acts on the examination zone during the displacement of the supporting device, each sequence producing a respective MR signal,

**characterized in that**, in order to form an MR image of a slice which is oriented perpendicularly or obliquely to the direction of motion, form one sequence to another

a) the frequency of the RF pulses and possibly additionally, in the case of an obliquely oriented slice,
b) the frequency and/or the phase position of the oscillator signal

is adjusted in conformity with the position of the object to be examined relative to the examination zone in such a manner that the part of the object which is imaged in the MR image moves in synchronism with the object.

## Revendications

1. Procédé de production d'images RMN dans lequel un objet à examiner est déplacé par rapport à une zone d'examen à une vitesse définie et plusieurs séquences agissent sur la zone d'examen en présence du champ magnétique homogène stationnaire, lesquelles comprennent respectivement au moins une impulsion à haute fréquence et au moins un champ à gradient magnétique et délivrent respectivement un signal RMN qui est utilisé après transformation à l'aide d'un signal d'oscillateur dans une autre plage de fréquence pour la production d'une image RMN, **caractérisé en ce que**, pour la production d'une image RMN d'une couche orientée perpendiculairement ou obliquement par rapport au sens de déplacement,

   a) la fréquence des impulsions à haute fréquence ou, éventuellement, en cas de couche orientée obliquement,
   b) la fréquence et/ou la position de phase du signal de l'oscillateur

   est réglée d'une séquence à l'autre en fonction de la position de l'objet à examiner par rapport à la zone d'examen de telle sorte que la zone représentée dans l'image RMN de l'objet à examiner se déplace de manière synchrone avec celui-ci.

2. Dispositif RMN de mise en oeuvre du procédé selon la revendication 1 avec:

   - un dispositif de positionnement en vue du positionnement d'un objet à examiner,
   - des moyens d'entraînement en vue de déplacement du dispositif de positionnement à une vitesse définie,
   - un aimant de production d'un champ magnétique stationnaire homogène,
   - des moyens de production d'impulsions à haute fréquence d'une fréquence à déterminer préalablement,
   - un montage de bobines à gradient en vue de la production de champs à gradient magnétique,
   - des moyens de réception des signaux RMN produits dans une zone d'examen, chaque signal RMN étant transformé à l'aide d'un signal d'oscillateur dans une autre plage de fréquence,
   - des moyens de production d'images RMN à partir des signaux RMN transformés dans la fréquence,
   - une unité de commande qui est agencée de telle sorte qu'elle commande les moyens d'entraînement, les moyens de production d'impulsions à haute fréquence, le montage des bobines à gradient et les moyens de réception des signaux RMN de telle sorte que, pendant l'avance du dispositif de positionnement, plusieurs des séquences agissent sur la zone d'examen et délivrent respectivement un signal RMN, **caractérisé en ce que**, pour la production d'une image RMN, une couche orientée obliquement ou perpendiculairement au sens de déplacement d'une séquence à l'autre

   a) la fréquence des impulsions à haute fréquence et, éventuellement, en cas de couche orientée obliquement,
   b) la fréquence et/ou la position de phase du signal de l'oscillateur

est réglée d'une séquence à l'autre en fonction de la position de l'objet à examiner par rapport à la zone d'examen de telle sorte que la zone représentée dans l'image RMN de l'objet à examiner se déplace de manière synchrone avec celui-ci.

FIG. 1

FIG. 2

9

FIG. 3

FIG. 4